# EUROPEAN PATENT APPLICATION

(11) **EP 4 700 833 A1**
(43) Date of publication of application: **25.02.2026**
(21) Application number: 23933722.3
(22) Date of filing: 26.09.2023
(51) Int. Cl.: H01L 31/05, H01L 31/048

(54) **PHOTOVOLTAIC ASSEMBLY, PHOTOVOLTAIC POWER GENERATION DEVICE AND PHOTOVOLTAIC POWER GENERATION SYSTEM**

(30) Priority: 20.04.2023 CN 202310435924
(71) Applicant: CHINT New Energy Technology Co., Ltd., Jiaxing, Zhejiang 314415 (CN)
(72) Inventor: HE, Chenxu, Jiaxing, Zhejiang 314415 (CN); JIN, Yeyi, Jiaxing, Zhejiang 314415 (CN); WU, Guoxing, Jiaxing, Zhejiang 314415 (CN); XU, Weizhi, Jiaxing, Zhejiang 314415 (CN)
(74) Representative: PGA S.p.A., Milano, Succursale di Lugano
(86) International application number: PCT/CN2023/121787
(87) International publication number: WO 2024/216852

(57) **Abstract**

The present application relates to the field of photovoltaic power generation. Disclosed are a photovoltaic assembly, a photovoltaic power generation device and a photovoltaic power generation system. The photovoltaic assembly comprises N cell strings, which are connected in series, wherein a first cell string is not connected in parallel to a bypass module, a second cell string is connected in parallel to a bypass module, there is at least one first cell string that is not provided with a corresponding bypass module, which is connected in parallel thereto, and the total number of cells in the first cell string is not less than the total number of cells in the second cell string, such that an output current of the first cell string is not greater than an output current of the second cell string, and an output voltage of the first cell string is not less than an output voltage of the second cell string, thereby facilitating a reduction in an output current of the photovoltaic assembly and an increase in an output voltage of the photovoltaic assembly, and reducing the internal heating of the assembly. A bypass module is usually arranged in a junction box, such that the solution is conducive to reducing the provision number of junction boxes and reducing the cost.

## Description

This application claims priority to the Chinese Patent Application No. 2023104359243, titled "PHOTOVOLTAIC ASSEMBLY, PHOTOVOLTAIC POWER GENERATION DEVICE AND PHOTOVOLTAIC POWER GENERATION SYSTEM", filed on April 20, 2023 with the China National Intellectual Property Administration, which is incorporated herein by reference in its entirety.

### FIELD

The present application relates to the technical field of photovoltaic power generation, and in particular to a photovoltaic module, a photovoltaic power generation device and a photovoltaic power generation system.

### BACKGROUND

Photovoltaic energy, as a kind of clean energy, has been increasingly valued by various countries. With the attainment of grid parity, the photovoltaic energy has been widely used in scenarios such as distributed rooftop installations.

Specifically, an output terminal of a photovoltaic module is connected to an inverter which converts DC power into AC power to feed into a power grid or devices such as a storage battery. The photovoltaic module includes multiple cell strings. At present, in the related art, each of the cell strings is typically provided with a bypass diode for a hot spot bypass. In the practical application, based on the production realities, the photovoltaic module has the following design shortcomings. The photovoltaic module is typically arranged on a rooftop, and the increase of the output current of the photovoltaic module would lead to a high operating temperature of the photovoltaic module. In a high-current and high-temperature operating environment, the encapsulation of the photovoltaic module is prone to aging, especially in a micro-shielded environment, and the transmission loss is also large under high current. It can be seen that it is necessary to appropriately reduce the output current of the photovoltaic module and increase the output voltage of the photovoltaic module. Moreover, the increase of the output voltage may cause the diode to be broken down and thus fail. Therefore, how to design a photovoltaic module that can reduce the output current of the photovoltaic module and increase the output voltage of the photovoltaic module as much as possible is an urgent technical issue to be addressed.

### SUMMARY

The present application is aimed to provide a photovoltaic module, a photovoltaic power generation device and a photovoltaic power generation system, which can reduce the output current of the photovoltaic module and increase the output voltage of the photovoltaic module, ensure safe operation of the entire photovoltaic module, reduce heat generated inside the photovoltaic module, improve anti-hotspot capability of the photovoltaic module, reduce the number of junction boxes and lower costs, and facilitate practical engineering applications.

To address the issues above, a photovoltaic module is provided according to the present application, including: N cell strings connected in series, where N is an integer not less than 2. Each of the N cell strings includes multiple cells which are connected according to a predetermined series-parallel arrangement. The N cell strings connected in series include a first cell string and a second cell string. The first cell string is not connected in parallel with any bypass module, the second cell string is connected in parallel with a bypass module, and a total number of cells in the first cell string is not less than a total number of cells in the second cell string, so that an output current of the first cell string is not greater than an output current of the second cell string and an output voltage of the first cell string is not less than an output voltage of the second cell string, where 1 ≤ a total number of the first cell string ≤ N.

In an optional embodiment, the cell string includes S substrings connected in parallel or in series, where S is an integer greater than 1. Each of the substrings includes multiple cells. The multiple cells are connected in series; or, Q1 cells of the multiple cells are connected in parallel with Q2 cells of the multiple cells, and Q1+Q2 = a total number of cells in the substring.

In an optional embodiment, each of the cells is a rectangular cell. The rectangular cell has a length less than a preset length threshold, a width less than a preset width threshold, and a thickness less than a preset thickness threshold.

In an optional embodiment, a difference between areas of any two rectangular cells is less than a difference reference. The difference reference = a predetermined percentage × a greater one of the areas of the two rectangular cells; and the area of the rectangular cell = the length of the rectangular cell × the width of the rectangular cell.

In an optional embodiment, each of the cells is a cell that meets a predetermined thermal dissipation and power consumption performance condition. The predetermined thermal dissipation and power consumption performance condition is as follows: when a reverse voltage is applied to the cell, a current density flowing through the cell is greater than a first preset threshold, and an absolute value of a terminal voltage of the cell is less than a second preset threshold.

In an optional embodiment, the total number of cells in the first cell string is greater than a preset cell-count threshold.

In an optional embodiment, the photovoltaic module further includes a front transparent panel, a front encapsulation film, a back encapsulation film, and a back encapsulation plate. The front transparent panel, the front encapsulation film, the N cell strings, the back encapsulation film, and the back encapsulation plate are stacked in sequence.

In an optional embodiment, each of the cells is a back-contact cell.

A photovoltaic power generation device is further provided according to the present application, which includes M photovoltaic modules as described above. The M photovoltaic modules are connected in series, and M is an integer not less than 1.

A photovoltaic power generation system is further provided according to the present application, which includes an inverter and the photovoltaic power generation device as described above. An output terminal of the photovoltaic power generation device is connected to an input terminal of the inverter.

The photovoltaic module, the photovoltaic power generation device and the photovoltaic power generation system are provided according to the present application. The photovoltaic module includes N cell strings connected in series. The N cell strings include the first cell string and the second cell string. No bypass module is provided to be connected in parallel with the first cell string, and the bypass module is provided to be connected in parallel with the second cell string. The total number of the first cell string is not less than 1. That is, there is at least one first cell string which is not provided with a corresponding bypass module connected in parallel with it. The total number of the cells in the first cell string is not less than the total number of the cells in the second cell string. As a result, the output current of the first cell string is not greater than the output current of the second cell string and the output voltage of the first cell string is not less than the output voltage of the second cell string, which reduces the output current of the photovoltaic module and increases the output voltage of the photovoltaic module, ensures safe operation of the entire photovoltaic module, and reduces heat generated inside the photovoltaic module. In addition, since the bypass module is typically arranged in a junction box, this solution facilitates reducing the number of the junction boxes and lowering costs, and facilitates the practical engineering applications.

### BRIEF DESCRIPTION OF THE DRAWINGS

To clearly describe the technical solutions in the embodiments of the present application, the following briefly introduces the accompanying drawings used in the related technologies and the embodiments. Obviously, the drawings described below are merely some of the embodiments of the present application. For those skilled in the art, other drawings can be obtained based on these drawings without creative work.
FIG. 1 is a schematic structural view of a photovoltaic module according to a first embodiment of the present application;
FIG. 2 is a schematic view of a back structure of the photovoltaic module of FIG. 1 according to the present application;
FIG. 3 is a schematic structural view of a photovoltaic module according to a second embodiment of the present application;
FIG. 4 is a schematic structural view of a photovoltaic module according to a third embodiment of the present application;
FIG. 5 is a schematic structural view of a photovoltaic module according to a fourth embodiment of the present application;
FIG. 6 is a schematic structural view of a photovoltaic module according to a fifth embodiment of the present application;
FIG. 7 is a schematic structural view of a photovoltaic module according to a sixth embodiment of the present application;
FIG. 8 is a schematic view of a back structure of the photovoltaic module of FIG. 7 according to the present application;
FIG. 9 is a schematic structural view of a photovoltaic module according to a seventh embodiment of the present application;
FIG. 10 is a schematic structural view of a photovoltaic module according to an eighth embodiment of the present application;
FIG. 11 is a schematic view of a back structure of the photovoltaic module of FIG. 10 according to the present application
FIG. 12 is a schematic structural view of a photovoltaic module according to a ninth embodiment of the present application;
FIG. 13 is a schematic structural view of a photovoltaic module according to a tenth embodiment of the present application;
FIG. 14 is a schematic structural view of a photovoltaic module according to an eleventh embodiment of the present application;
FIG. 15 is a schematic structural view of a photovoltaic module according to a twelfth embodiment of the present application;
FIG. 16 is a schematic structural view of a photovoltaic module according to a thirteenth embodiment of the present application; and
FIG. 17 is another schematic view of a back structure of the photovoltaic module of FIG. 1 according to the present application.

### DETAILED DESCRIPTION OF THE EMBODIMENTS

The core of the present application is to provide a photovoltaic module, a photovoltaic power generation device, and a photovoltaic power generation system, which reduce the output current of the photovoltaic module and increase the output voltage of the photovoltaic module, ensure safe operation of the entire photovoltaic module, reduce the heat generation inside the photovoltaic module, improve anti-hotspot capability of the photovoltaic module, reduce the number of junction boxes and lower costs, and facilitate the practical engineering applications.

In order to make the objectives, technical solutions, and advantages of the embodiments of the present application more clear, the technical solutions in the embodiments of the present application are described clearly and completely in conjunction with the accompanying drawings in the embodiments of the present application. It is apparent that the described embodiments are only some of the embodiments of the present application, rather than all of the embodiments. All other embodiments obtained by those skilled in the art based on the embodiments of the present application without creative work fall within the protection scope of the present application.

### Embodiment 1

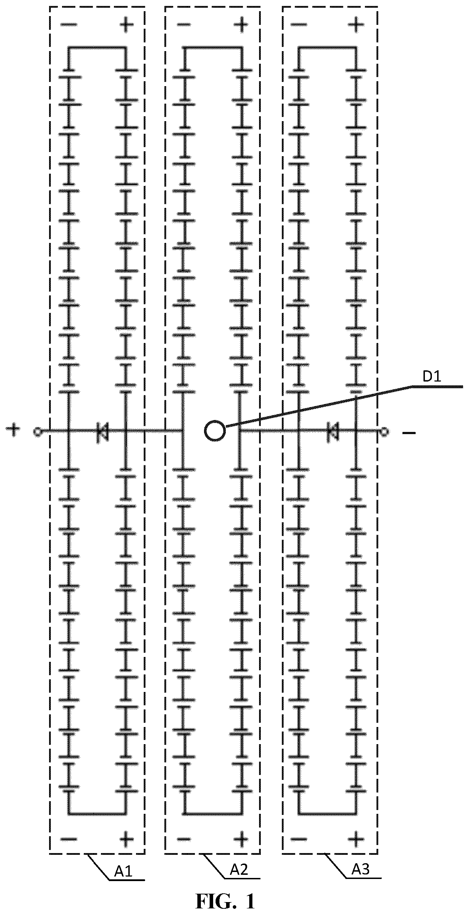

Referring to FIG. 1, a photovoltaic module includes N cell strings connected in series, where N is an integer not less than two. Each of the cell strings includes multiple cells which are connected according to a predetermined series-parallel arrangement. The N cell strings connected in series include a first cell string and a second cell string. No bypass module is provided to be connected in parallel with the first cell string, and a bypass module is provided to be connected in parallel with the second cell string. The total number of cells in the first cell string is not less than the total number of cells in the second cell string. As a result, an output current of the first cell string is not greater than an output current of the second cell string, an output voltage of the first cell string is not less than an output voltage of the second cell string, and 1 ≤ the total number of the first cell string ≤ N.

In the embodiment, the bypass module is a bypass diode.

In the embodiment, the following fact is considered that: in the related art, each cell string of a photovoltaic module is provided with a bypass diode. In the practical application, since the photovoltaic module is typically arranged on a rooftop, the large output current of the photovoltaic module may result in an increase of transmission loss, and may lead to a high operating temperature of the photovoltaic module. In this operating environment, the encapsulation of the photovoltaic module is highly prone to aging, and the configuration in the related art is not conducive to achieving high output voltage of the photovoltaic module. To address the above technical issues, a photovoltaic module is provided according to the present application, which is beneficial to reducing the output current of the photovoltaic module and increasing the output voltage of the photovoltaic module, thereby ensuring the safe operation of the entire photovoltaic module.

Specifically, the photovoltaic module may be directly connected to an inverter, so that the inverter can convert DC power output by the photovoltaic module into AC power to feed into the power grid or an energy storage module; alternatively, multiple photovoltaic modules may be connected in series and then connected to an inverter, which is not limited herein. Based on actual needs, the photovoltaic module specifically includes N cell strings connected in series, and the N cell strings are divided into two parts: a first cell string and a second cell string. The first cell string is not connected in parallel with any bypass module, and the second cell string is connected in parallel with a bypass module. Herein, the bypass module includes but is not limited to a bypass diode, which is specifically provided in a junction box. Regarding the number of the first cell strings, 1 ≤ the total number of the first cell string ≤ N, that is, there is at least one first cell string which is not provided with a corresponding bypass module connected in parallel with it (all of the N cell strings may be the first cell strings based on the actual situation). It is advantageous to arrange more cells in the first cell string, that is, the total number of cells in the first cell string is not less than the total number of cells in the second cell string, so that the output current of the first cell string is not greater than the output current of the second cell string and the output voltage of the first cell string is not less than the output voltage of the second cell string. The N cell strings are connected in series, and in this series circuit configuration, the output current of the photovoltaic module is the minimum of the output currents of the N cell strings connected in series. Therefore, the output current of the photovoltaic module is determined by the output current of the first cell string, thereby reducing the output current of the photovoltaic module. In order to ensure the anti-hotspot capability of the photovoltaic module, the cell in each cell string include, but is not limited to, an anti-hotspot cell, and the anti-hotspot cell include but is not limited to a back-contact cell.

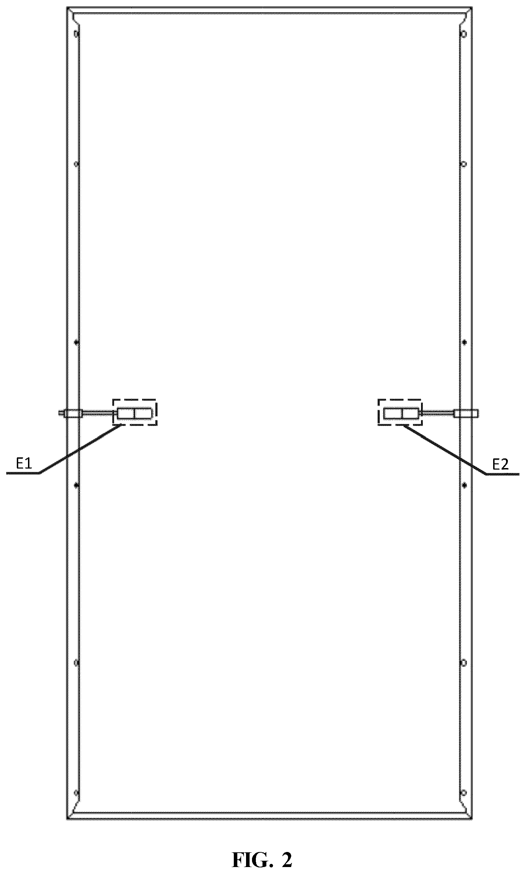

Referring to FIG. 1, as an example for illustration, N is equal to 3. The three cell strings are connected in series through a bus bar. A second cell string A1 and a second cell string A3 are provided on two sides, and a first cell string A2 is provided in the middle. Taking the second cell string A1 as an example for illustration, the second cell string A1 has an external lead wire to be connected to a bypass diode. The first cell string A2 has no external lead wire for connecting a bypass diode and is arranged in the middle, so the first cell string A2 does not need to be directly connected to a connector and does not need to be provided with a junction box, thereby saving the cost of providing the junction box. If the first cell string is arranged at the edge, it needs to be provided with a junction box for connecting the connector, and no bypass diode is provided in the junction box. Further referring to FIG. 2, FIG. 2 shows the arrangement of the back of the photovoltaic module corresponding to FIG. 1, that is, the external lead wire of the second cell string A1 is connected to a junction box E1 to be connected in parallel with the bypass diode in the junction box E1, and the external lead wire of the second cell string A3 is connected to a junction box E2 to be connected in parallel with the bypass diode in the junction box E2.

It should be noted that, in FIG. 1, as an example for illustration, the first cell string A2, the second cell string A1, and the second cell string A3 contain the same number of cells. In the practical application, the first cell string A2 may contain more cells, for example, the number of cells in the first cell string A2 is 26 or even more, which is not limited herein. Moreover, the first cell string is arranged in the middle or at the edge, which is not particularly limited herein. As shown in FIG. 1, the cell string in the middle may be connected in parallel with a bypass diode which is specifically arranged at a position where a circle D1 is located, and one of the cell strings at the edge may be selected as the first cell string that is not provided with a corresponding bypass diode.

It can be seen that a photovoltaic module is provided according to the present application, which can reduce the output current of the photovoltaic module and increase the output voltage of the photovoltaic module, ensure the safe operation of the entire photovoltaic module, and reduce heat generated inside the photovoltaic module. In addition, since the bypass module is typically arranged in the junction box, this solution can reduce the number of junction boxes and lower costs, and facilitate the practical engineering applications.

In an embodiment, the cell string includes S substrings which are connected in parallel or in series, where S is an integer greater than 1, and each of the substrings includes multiple cells. The multiple cells are connected in series; or, Q1 cells of the multiple cells are connected in parallel with Q2 cells of the multiple cells, where Q1+Q2=the total number of cells in the substring.

In the embodiment, the configuration for connecting the cells in the cell strings according to a predetermined series-parallel arrangement is specified. Specifically, the above connection manner is further illustrated below with practical examples.

First, referring to FIG. 1, N is equal to 3, S is equal to 2, and the substring is a cell string composed of cells arranged in a column. Taking the second cell string A1 as an example, based on the circuit structure, assuming that the bypass diode is regarded as a dividing line, multiple cells in a substring (for example, located in the left column) are essentially configured as a parallel-connected structure. That is, in the substring, 12 cells in an upper half part above the dividing line are connected in parallel with 12 cells in a lower half part below the dividing line. Therefore, the analysis of the series-parallel relationship among the substrings requires focusing on the upper half parts of the substrings. It can be seen that the substring of the left column is connected in series with the substring of the right column. The analysis of the circuit structure of the first cell string A2 and the second cell string A3 is similar to that of the second cell string A1, which is not repeated here.

In an embodiment, each of the cells is a rectangular cell. The rectangular cell has a length less than a preset length threshold, a width less than a preset width threshold, and a thickness less than a preset thickness threshold.

In the embodiment, in order to further standardize the cell, the cell is configured as a rectangular cell, and the length, the width, and the thickness of the rectangular cell are limited (each of the length, the width, and the thickness is greater than 0). Specifically, as a preferred example, in the practical application, the preset length threshold is 450mm so that the length of the rectangular cell is less than 450mm, the preset width threshold is 450mm so that the width of the rectangular cell is less than 450mm, and the preset thickness threshold is 300um so that the thickness of the rectangular cell is less than 300um. The specific parameters may be set based on the actual application. For example, the length of the rectangular cell may be equal or unequal to the width of the rectangular cell, so as maximize the utilization of the mounting area of a back panel of the photovoltaic module.

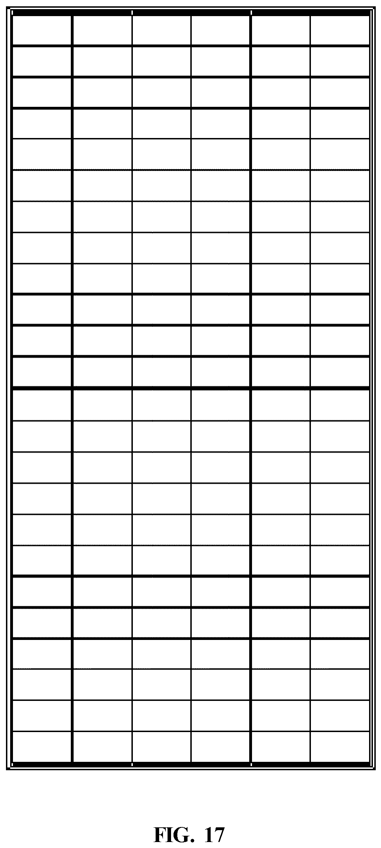

Referring to FIG. 17, FIG. 17 is another schematic view of the back structure of the photovoltaic module according to the present application, and shows the schematic view of the arrangement of the photovoltaic module, which is provided with the cells, corresponding to FIG. 1.

In an embodiment, a difference between areas of any two rectangular cells is less than a difference reference, where the difference reference = a predetermined percentage × a greater one of the areas of the two rectangular cells, and the area of the rectangular cell = the length of the rectangular cell × the width of the rectangular cell.

In the embodiment, in order to standardize, it is ensured that the currents among the cells are as consistent as possible, it is further specified that the difference between the areas of any two rectangular cells is less than the difference reference. Specifically, for example, assuming that an area of one of the two rectangular cells is J1, an area of the other of the two rectangular cells is J2, and J2 is greater than J1, then the difference between J2 and J1 is less than the predetermined percentage × J2. In an embodiment, the predetermined percentage is, but not limited to, 5%, which is not particularly limited herein.

In an embodiment, the cell is a cell that meets a predetermined thermal dissipation and power consumption performance condition. The predetermined thermal dissipation and power consumption performance condition is as follows: when a reverse voltage is applied to the cell, a current density flowing through the cell is greater than a first preset threshold, and an absolute value of a terminal voltage of the cell is less than a second preset threshold.

In the embodiment, in order to ensure that the emission power consumption of each cell is at a low level as much as possible, it is further specified that the cell is a cell meet the predetermined thermal dissipation and power consumption performance condition. In an embodiment, when a reverse voltage is applied to the cell, the current density flowing through the cell is less than 20mA/cm² (i.e., the first preset threshold), and the absolute value of the terminal voltage of the cell is less than 6.5V (i.e., the second preset threshold). In the practical application, the first and second preset thresholds may be flexibly determined according to the needs.

In an embodiment, the total number of the cells in the first cell string is greater than a preset cell-count threshold.

In the embodiment, the preset cell-count threshold may be 26, so that the photovoltaic module at least includes one first cell string having more than 26 cells.

In an embodiment, the photovoltaic module further includes a front transparent panel, a front encapsulation film, a back encapsulation film, and a back encapsulation plate. The front transparent panel, the front encapsulation film, the N cell strings, the back encapsulation film, and the back encapsulation plate are stacked in sequence.

In the embodiment, in the practical application, the N cell strings in the photovoltaic module are encapsulated at a third layer of the sequentially stacked structure, and such encapsulation structure is convenient for the practical application.

In an embodiment, the cell is a back-contact cell.

In the embodiment, the back of the back-contact cell has a high-doping and alternately arranged p+/n+ design structure, heat generated by the back-contact cell is dispersed when the back-contact cell is shaded, and localized heating does not occur in the back-contact cell, so the back-contact cell has a good anti-hotspot performance and has no busbars on the front side. Therefore, the cell may be a back-contact cell. Furthermore, it can be understood that, in the related art, due to the existence of the bypass diodes, when a cell in the cell string of the photovoltaic module is shaded, the bypass diode corresponding to the cell string will conduct. Consequently, the output of the cell string is cut off, resulting in a decrease of the output voltage of the photovoltaic module. In the present application, the first cell string does not have a corresponding bypass module, and the first cell string itself includes a back-contact cell to achieve the anti-hotspot function, and therefore, the impact on the output voltage of the whole first cell string is relatively weak even if one back-contact cell in the first cell string is shaded. That is, the output voltage of the photovoltaic module according to the present application is still relatively high, so as to ensure the operation reliability of the photovoltaic module.

A photovoltaic power generation device is further provided according to the present application, which includes M photovoltaic modules as described above, and the M photovoltaic modules are connected in series, where M is an integer not less than 1.

The description of the photovoltaic power generation device according to the present application refers to the above embodiments of the photovoltaic module, which is not repeated here.

A photovoltaic power generation system is further provided according to the present application, which includes an inverter and the photovoltaic power generation device as described above. An output terminal of the photovoltaic power generation device is connected to an input terminal of the inverter.

In the embodiment, the description of the photovoltaic power generation system according to the present application refers to the above embodiments of the photovoltaic module, which is not repeated here. In addition, an output terminal of the inverter may be connected to the power grid or an energy storage module.

### Embodiment 2

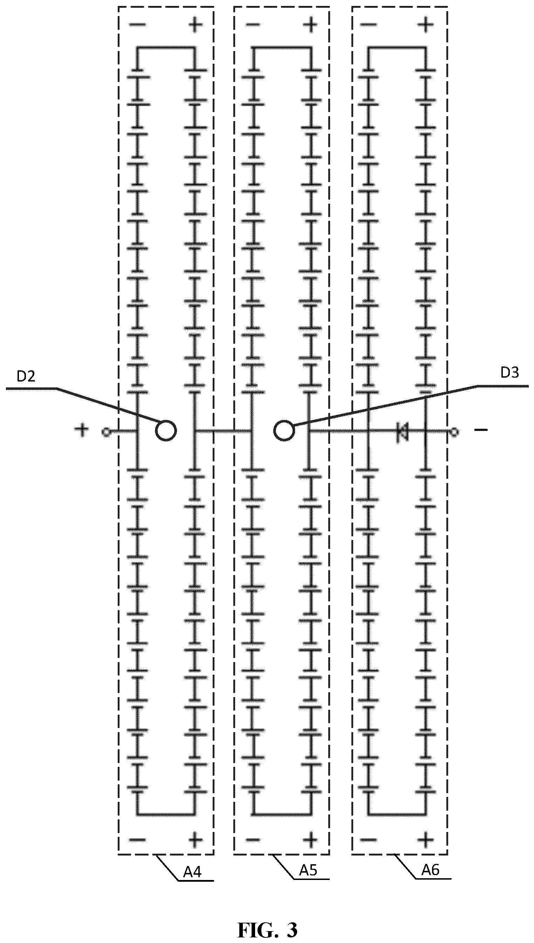

As shown in FIG. 3, as an example for illustration, N is equal to 3, and the photovoltaic module includes a first cell string A4, a first cell string A5, and a second cell string A6. The analysis of the circuit structure is the same as that of the Embodiment 1. It can be understood that, in FIG. 3, a cell string at the edge is selected as the second cell string A6. Alternatively, the current first cell string A3 or A4 may be selected as the second cell string, the current second cell string A6 may be selected as the first cell string, and correspondingly, the bypass diode may be arranged at the position where a circle D2 or a circle D3 is located.

### Embodiment 3

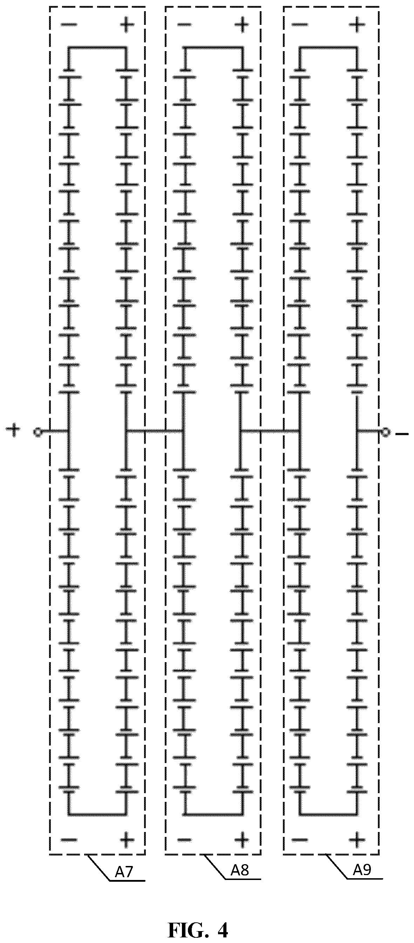

As shown in FIG. 4, as an example for illustration, N is equal to 3, and the photovoltaic module includes a first cell string A7, a first cell string A8, and a first cell string A9. The analysis of the circuit structure is the same at that of the Embodiment 1. Each of the first cell string A7, the first cell string A8, and the first cell string A9 have no external lead wire for connecting the bypass diode.

### Embodiment 4

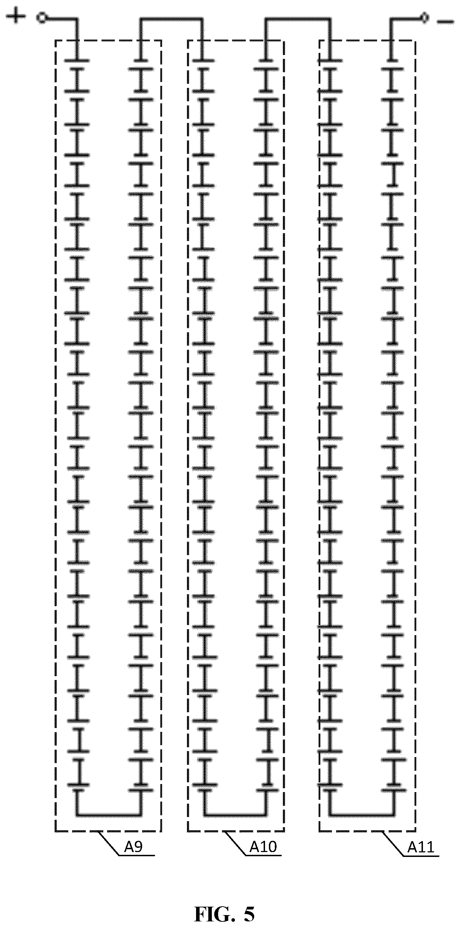

As shown in FIG. 5, as an example for illustration, N is equal to 3, and the photovoltaic module includes a first cell string A9, a first cell string A10, and a first cell string A11. Taking the first cell string A9 as an example, the first cell string A9 includes two substrings, that is, S is equal to 2, and a substring in the left column is one of the two substrings, and a substring in the right column is the other of the two substrings. By analyzing the circuit structure show in the figure, it can be seen that the two substrings are connected in series, and the cells in the substring are also connected in series.

### Embodiment 5

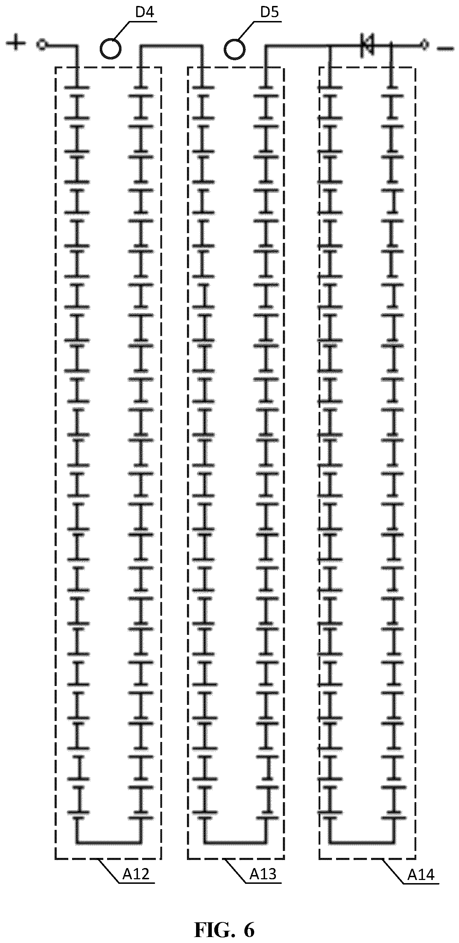

As shown in FIG. 6, as an example for illustration, N is equal to 3, and the photovoltaic module includes a first cell string A12, a first cell string A13, and a second cell string A14. The analysis of the circuit structure is the same as above. It can be understood that, in this case, the current first cell string A12 or A13 may be selected as the second cell string, and the current second cell string A14 may be selected as the first cell string. Correspondingly, the bypass diode is arranged at the position where a circle D4 or a circle D5 is located.

### Embodiment 6

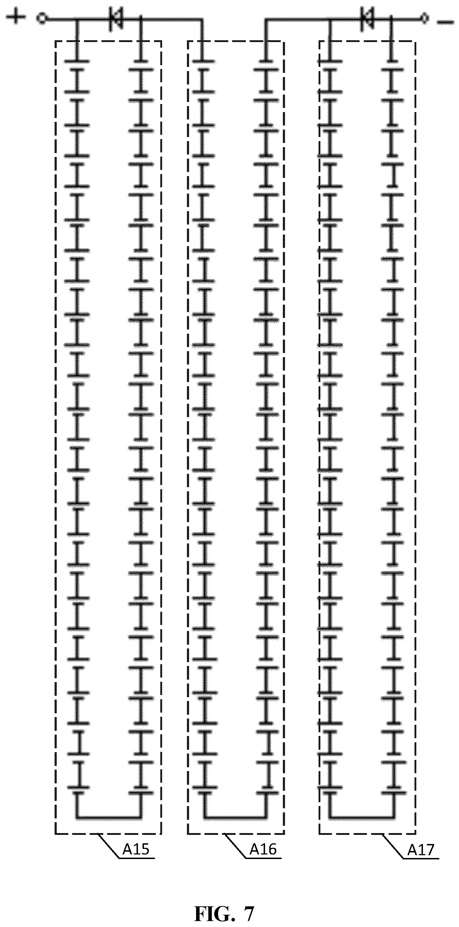

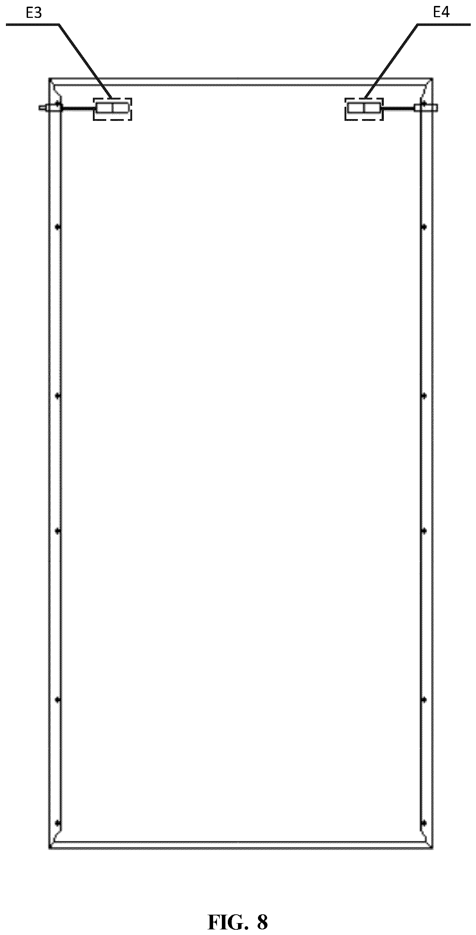

As shown in FIG. 7 and FIG. 8, as an example for illustration, N is equal to 3, and the photovoltaic module includes a first cell string A16, a second cell string A15, and a second cell string A17. The analysis of the circuit structure is the same as that of the Embodiment 1. Each of a junction box E3 and a junction box E4 includes a bypass diode corresponding to FIG. 7.

### Embodiment 7

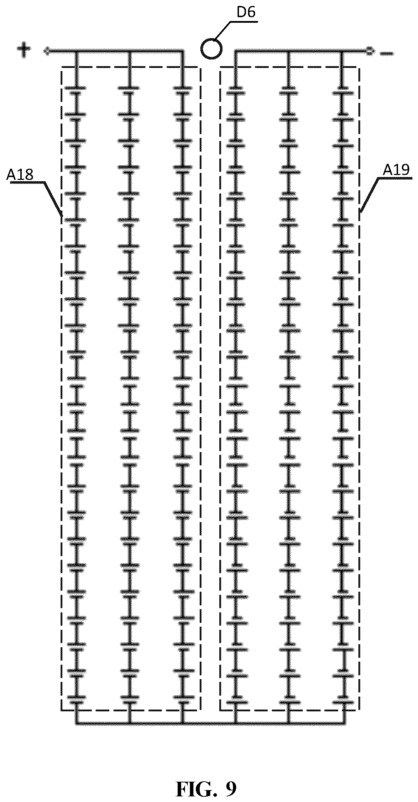

As shown in FIG. 9, as an example for illustration, N is equal to 2, and the photovoltaic module includes a first cell string A18 and a first cell string A19. If a bypass diode is provided based on actual needs, it may be arranged at the position where a circle D6 is located. In addition, taking the first cell string A18 as an example, the first cell string A18 includes three substrings, that is, S is equal to 3, and a left column is one of the three substrings, a middle column is another of the three substrings, and a right column is yet another of the three substrings. The three substrings are connected in parallel, and the cells in each of the substrings are connected in series.

### Embodiment 8

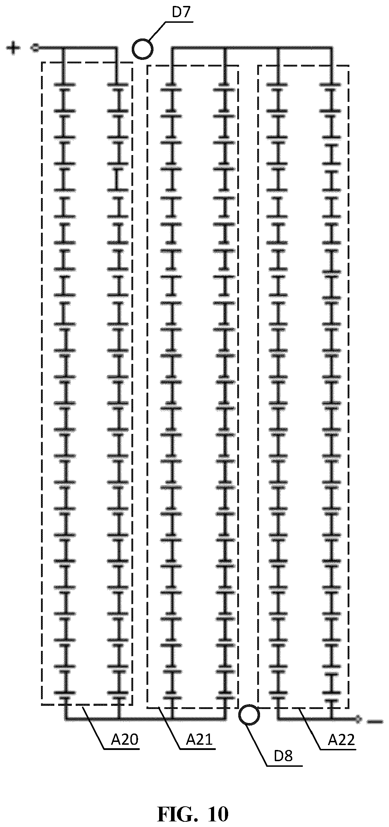

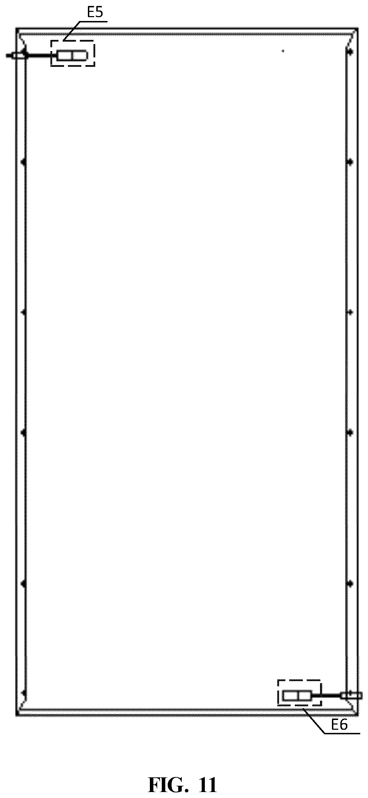

As shown in FIG. 10 and FIG. 11, as an example for illustration, N is equal to 3, and the photovoltaic module includes a first cell string A20, a first cell string A21, and a first cell string A22. If bypass diodes are provided based on actual needs, they may be arranged at the positions where circles D7 and D8 are located. FIG. 11 is a schematic diagram of a back structure of the photovoltaic module corresponding to FIG. 10, where the bypass diodes are provided at the two positions where circles D7 and D8 are located. Each of a junction box E5 and a junction box E6 includes the bypass diode. In addition, with reference to FIG. 10, taking the first cell string A20 as an example, the first cell string A20 includes two substrings, that is, S is equal to 2, and a left column is one of the two substrings and a right column is the other of the two substrings. The two substrings are connected in parallel, and the cells in each of the substrings are connected in series.

### Embodiment 9

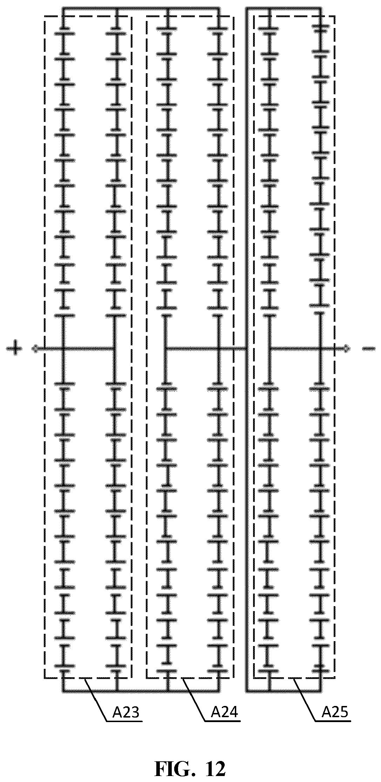

As shown in FIG. 12, as an example for illustration, N is equal to 3, and the photovoltaic module includes a first cell string A23, a first cell string A24, and a first cell string A25. For the analysis of this complex circuit structure of FIG. 12, reference is made to the analysis of FIG. 1. Taking the first cell string A23 as an example, based on the circuit structure, assuming that a positive output terminal (labeled as "+" in FIG. 12) and a negative output terminal (labeled as "-" in FIG. 12) of the photovoltaic module are regarded as a dividing line, a substring (for example, located at a left column) is essentially configured as a parallel-connected structure. That is, in one substring, 12 cells in an upper half part above the dividing line are connected in parallel with 12 cells in a lower half part below the dividing line. As a result, the analysis of the series-parallel relationship among the substrings requires focusing on the upper half parts of the substrings. It can be seen that the upper half part of the substring in the left column is connected in parallel with the upper half part of the substring in the right column. The same analysis applies to the first cell string A24 and the first cell string A25. It can be understood that the upper half part of the first cell string A23 is connected in series with the upper half part of the first cell string A24 and then is connected in series with the upper half part of the first cell string A25. The specific series connection manner is shown in FIG. 12.

### Embodiment 10

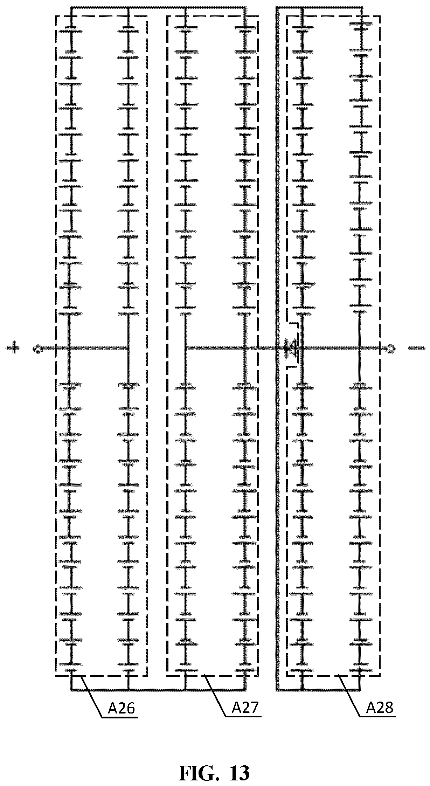

As shown in FIG. 13, a schematic view is provided to illustrate the arrangement of a bypass diode based on the circuit structure of the Embodiment 9. In FIG. 13, as an example for illustration, N is equal to 3, and the photovoltaic module includes a first cell string A26, a second cell string A27, and a second cell string A28. The analysis of the circuit structure is the same as that of the Embodiment 1.

### Embodiment 11

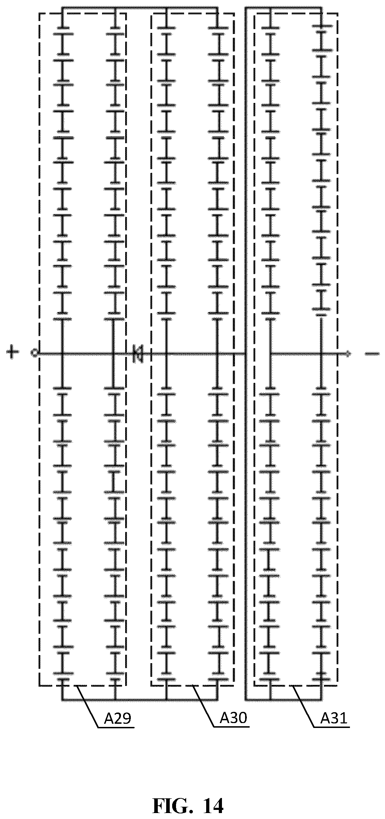

As shown in FIG. 14, a schematic view is provided to illustrate the arrangement of a bypass diode based on the circuit structure of the Embodiment 9. As an example for illustration, N is equal to 3, and the photovoltaic module includes a second cell string A29, a second cell string A30 and a first cell string A31. The analysis of the circuit structure is the same as that of the Embodiment 1.

### Embodiment 12

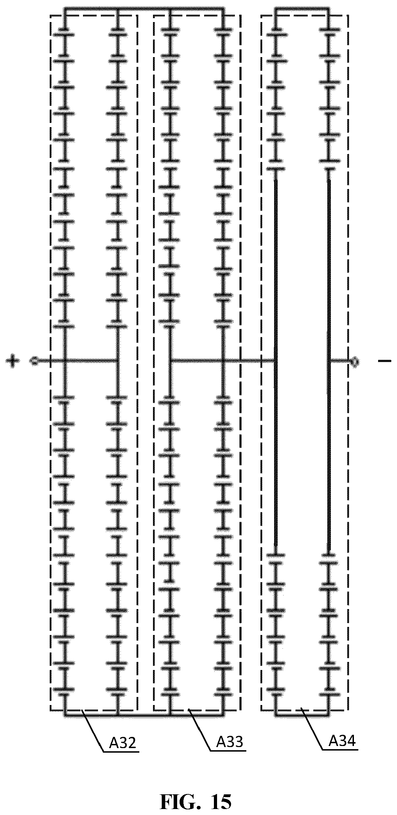

As shown in FIG. 15, as an example for illustration, N is equal to 3, and the photovoltaic module includes a first cell string A32, a first cell string A33, and a first cell string A34. For the analysis of this complex circuit structure, reference is made to the above analysis. Taking the first cell string A32 as an example, based on the circuit structure, assuming that a positive output terminal (labeled as "+" in FIG. 15) and a negative output terminal (labeled as "-" in FIG. 15) of the photovoltaic module are regarded as a dividing line, a substring (for example, located at a left column) is essentially configured as a parallel-connected structure. That is, in one substring, 12 cells in an upper half part above the dividing line are connected in parallel with 12 cells in a lower half part below the dividing line. As a result, the analysis of the series-parallel relationship among the substrings requires focusing on the upper half parts of the substrings. It can be seen that the upper half part of the substring in the left column is connected in parallel with the upper half part of the substring in the right column. The same analysis applies to the first cell string A33. The first cell string A34 includes two substrings, i.e. a substring in a left column and a substring in a right column. The two substrings are connected in series, and in each substring, the cells in the upper half part above the dividing line are connected in parallel with the cells in the lower half part below the dividing line. In summary, FIG. 15 can be interpreted as follows: the upper half part of the first cell string A32 is connected in series with the upper half part of the first cell string A33 and then is connected in series with the upper half part of the first cell string A34.

It should be noted that, since the substrings in the first cell string A32 are connected in parallel, the substrings in the first cell string A33 are connected in parallel, and the substrings in the first cell string A34 are connected in series. As a result, in order to ensure that the currents of the substrings that are finally connected in series are the same, the number of cells in the first cell string A34 is half of the number of cells in the first cell string A32 or the first cell string A33. Moreover, in the practical application, in order to ensure that the area occupied by the cells in each first cell string is the same, the area occupied by each cell in the first cell string A34 may be doubled.

### Embodiment 13

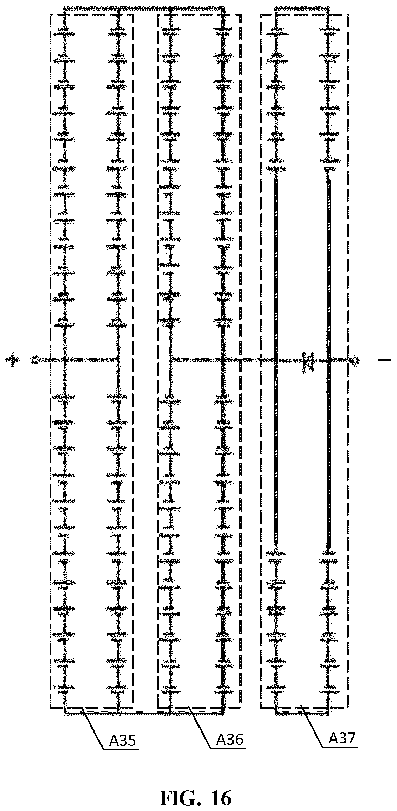

FIG. 16 shows a schematic view to illustrate the arrangement of a bypass diode based on the circuit structure of FIG. 15. As an example for illustration, N is equal to 3, and the photovoltaic module includes a first cell string A35, a first cell string A36, and a second cell string A37. The analysis of the circuit structure is the same as that of the Embodiment 1

The various embodiments in the specification are described in a progressive manner, and each embodiment focuses on the difference from other embodiments. The same and similar parts among the embodiments can be referred to each other. For the device disclosed in the embodiments, as it corresponds to the method disclosed in the embodiments, the description of the device is relatively simple, and the relevant parts can be referred to the description of the method. Relationship terms such as first and second are only used to distinguish one entity or operation from another, and do not necessarily require or imply any such actual relationship or order among these entities or operations. Moreover, the terms "include", "contain", or any other variation thereof are intended to indicate a non-exclusive inclusion, so that a process, a method, an item, or a device that includes a series of elements includes not only those elements, but also other elements not explicitly listed, or further includes elements inherent to such process, method, item, or device. Without more constraints, an element defined by the expression "comprises a ... " does not exclude the existence of another identical element in the process, method, item, or device that includes the element.

## Claims

1. A photovoltaic module, **characterized by** comprising:
N cell strings connected in series, wherein
N is an integer not less than 2, and each of the N cell strings comprises a plurality of cells connected according to a predetermined series-parallel arrangement;
the N cell strings connected in series comprise a first cell string and a second cell string; and
the first cell string is not connected in parallel with any bypass module, the second cell string is connected in parallel with a bypass module, and a total number of cells in the first cell string is not less than a total number of cells in the second cell string, so that an output current of the first cell string is not greater than an output current of the second cell string and an output voltage of the first cell string is not less than an output voltage of the second cell string, wherein 1 ≤ a total number of the first cell string ≤ N.

2. The photovoltaic module according to claim 1, wherein
the cell string comprises S substrings connected in parallel or in series, wherein S is an integer greater than 1; and
each of the substrings comprises a plurality of cells, wherein
the plurality of cells are connected in series; or, Q1 cells of the plurality of cells are connected in parallel with Q2 cells of the plurality of cells, and Q1+ Q2 = a total number of cells in the substring.

3. The photovoltaic module according to claim 1, wherein
each of the cells is a rectangular cell; and
the rectangular cell has a length less than a preset length threshold, a width less than a preset width threshold, and a thickness less than a preset thickness threshold.

4. The photovoltaic module according to claim 3, wherein
a difference between areas of any two rectangular cells is less than a difference reference, wherein the difference reference = a predetermined percentage × a greater one of the areas of the two rectangular cells; and
the area of the rectangular cell = the length of the rectangular cell × the width of the rectangular cell.

5. The photovoltaic module according to claim 1, wherein
each of the cells is a cell that meets a predetermined thermal dissipation and power consumption performance condition, wherein
the predetermined thermal dissipation and power consumption performance condition is as follows: when a reverse voltage is applied to the cell, a current density flowing through the cell is greater than a first preset threshold, and an absolute value of a terminal voltage of the cell is less than a second preset threshold.

6. The photovoltaic module according to claim 1, wherein
the total number of cells in the first cell string is greater than a preset cell-count threshold.

7. The photovoltaic module according to claim 1, further comprising a front transparent panel, a front encapsulation film, a back encapsulation film, and a back encapsulation plate, wherein
the front transparent panel, the front encapsulation film, the N cell strings, the back encapsulation film, and the back encapsulation plate are stacked in sequence.

8. The photovoltaic module according to any one of claims 1 to 7, wherein
each of the cells is a back-contact cell.

9. A photovoltaic power generation device, comprising M photovoltaic modules according to any one of claims 1 to 8, wherein
the M photovoltaic modules are connected in series, and M is an integer not less than 1.

10. A photovoltaic power generation system, comprising:
an inverter; and
the photovoltaic power generation device according to claim 9, wherein
an output terminal of the photovoltaic power generation device is connected to an input terminal of the inverter.
